# EUROPEAN PATENT APPLICATION

(11) **EP 1 640 731 A2**
(43) Date of publication of application: **29.03.2006**
(21) Application number: 05108377.2
(22) Date of filing: 13.09.2005
(51) Int. Cl.: G01R 11/04

(54) **Support housing for meters in a meter cabinet**

(30) Priority: 28.09.2004 IT RM20040460
(71) Applicant: BTICINO S.P.A., 20154 Milano (IT)
(72) Inventor: Re, Marcello, I-21040, VENEGONO SUPERIORE (Varese) (IT); De Cherubini, Sergio, I-21100, VARESE (IT)
(74) Representative: Siniscalco, Fabio

(57) **Abstract**

The structure comprises an elongated box-shaped housing (10), a plurality of power metal bars (20) which are arranged in the housing (10) substantially perpendicular to the housing longitudinal direction and substantially parallel to each other, a plurality of interconnection metal bars (21) which substantially parallel to each other, each interconnection metal bar being connected to a corresponding power metal bar (20), a terminal board (12) attached to the housing (10) for electrical connection to a plurality of user electrical networks, a plurality of positions (11) on a wall of the housing for mounting and electrically connecting power meters, each position (11) having associated thereto a power meter input electrical connection group (16).

## Description

This invention relates to a support and electrical connection structure for electric power meters.

Electric power distribution systems for buildings with a number of living units require that a power meter is provided for each living unit. Usually, the power meters are installed, in case together with other electrical apparatus, into a dedicated room which receives the ends of both the power wires derived from the public distribution network of the electrical power distribution company and the wires leading to the user networks in the single living units.

At present, installing power meters requires several manual operations, such as mounting individual apparatus to a wall, or a dedicated panel attached to a wall, and electrically connecting each apparatus to the distribution network wires and the user networks wires. These operations are relatively expensive because they have to be carried out by expert electricians and in any case can lead to wiring errors.

An object of this invention is to provide a support and electrical connection structure for electric power meters that allows to avoid or at lest mitigate the above explained disadvantage.

This object is attained by implementing the structure as defined broadly in claim 1.

The invention will be better understood from the following detailed description of an embodiment thereof given by way of example and therefore in no limiting sense, with reference with the attached drawings, wherein:
- figure 1 is a perspective view of a support and electrical connection structure for electric power meters according to the invention,
- figure 2 shows a portion of the structure of figure 1 partially opened,
- figure 3 is a partial perspective view of a combination of structures like the one of figures 1 and 2,
- figure 4 is a perspective view of the combination of figure 3 with power meters and other accessories mounted on the structures, and
- figure 5 is a perspective partial top view of the combination according to figure 4.

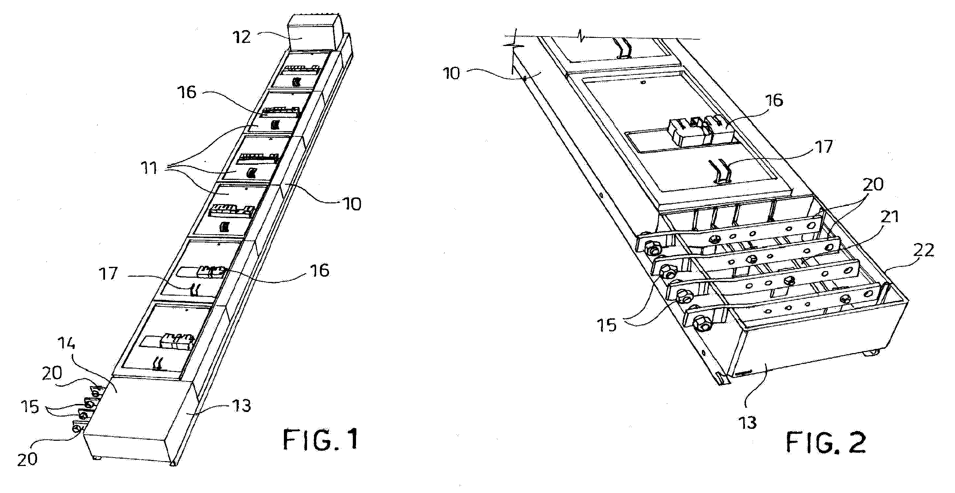

The structure of figure 1 comprises an elongated box-shaped housing 10, which for the sake of conciseness will be referred to as a column in the following description. The column has a front panel provided with six power meter mounting positions 11 (four three-phase and two single-phase power meters in this example) and a terminal board 12 at an end of the column. At its opposite end the column 10 has a space 13 that is closed by a cover 14. Four terminals 15 with bolts for fastening power wires (three phase conductors and one neutral conductor, not shown) derived from the public distribution network project from a side of the space 13. Each mounting position 11 is provided with a plug-in connection member 16 for the input terminals of a power meter (not shown in this figure) and a group of terminals 17 (two for the single-phase meters and four for the three-phase meters) to be connected to the meter output terminals, for example in the form of screw clamps. Advantageously, the power meters and their positions can be embodied as described in the Italian patent application n. RM2001A00595 filed by the applicant on 3 October 2001.

As can be seen in figure 2, which shows a space 13 without its cover 14, the terminals 15 with bolts are the ends of four bars 20, referred to as power bars in the following description, of a metal, such as copper. The power bars 20 are mounted within the space 13 parallel to each other and perpendicular to the longitudinal direction of column 10. Four additional metal bars 21, for example copper bars again, which will be referred to as vertical bars in the following description, are mounted in column 10 parallel to each other and perpendicular to the power bars 20. Each of the vertical bars 21 has one end bent at a right angle and fixed to a respective power bar 20 through a bolt.

Advantageously, the vertical bars 21 are distribution bars of the kind protected against accidental contacts, for example as described in document EP-A-1049227.

The plug-in connection members 16 are attached to the vertical bars 21, namely either to a phase bar and to a neutral bar in the case of a single-phase power meter, or to the three phase bars and to the neutral bar in the case of a three-phase power meter. Advantageously, all of the connection members 16 are mounted on plates of the same size, so that each position 11 can accommodate interchangeably either a single-phase or a three-phase meter. Furthermore, the connection members for single-phase meters can be shaped to be selectively connected to one or to another of the vertical bars 21, i.e. to a selected one of the three phases, so as to allow a balanced load distribution among the three phases. The terminals of groups 17 are connected to the clamps of terminal board 12 through electrical wires (not shown) inside the column 10.

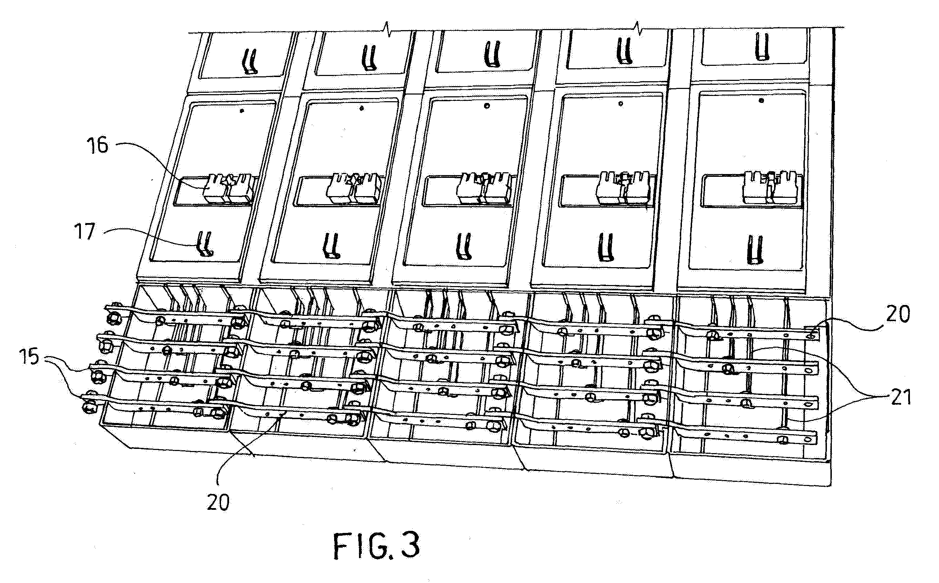

In the case that the number of the power meters to be installed is larger than the number of the positions available on a column, it is possible to arrange several columns side-by-side, as shown in figure 3. This can be made by removing a lateral lid 22 (figure 2) at the bottom end of each column with the exception of the last one and connecting the connection terminals of the power bars in each column to the internal ends of the bars of the adjacent column. To this end, the bar internal ends are provided with holes for accommodating fixing bolts.

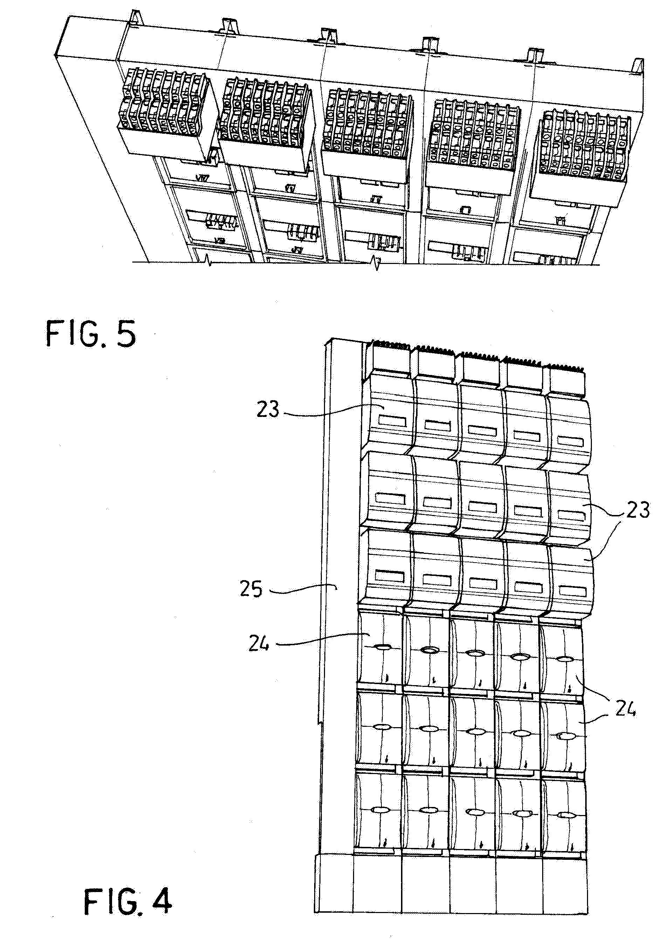

Figure 4 is a general view of a power meter board at the end of the mounting operation. The board is formed by the combination of five columns which are arranged side-by-side. Three power meters 23 are mounted to each column. The free positions are covered by lids 24. A channel 25 is provided along the free side of the lefthand column from which the terminals connected to the wires of the public distribution network extend, to insure a protected passage for the wires and a cover for the terminals. The power meters, the lids and the channel may be provided with seals or other anti-tamper means (not shown).

Figure 5 is a top view of the column combination according to figure 4 (without power meters) showing the terminal boards in detail.

As appears from the above description, the object of the invention is fully attained. Namely, in the structure according to the invention the power meters can be mounted without any manual wiring operation and therefore at a low cost and avoiding any possible wiring error. The only operation that may be required is fastening the screws of the output terminals of the power meters. Furthermore, the structure according to the invention lends itself to the provision of power meter boards of any size, due to the possibility of combining any number of columns. An additional advantage, as outlined above, is the possibility of equally distributing the consumption loads simply by choosing the connection members 16 for the single-phase meters according to their predetermined connection configuration to the various phase conductors.

## Claims

1. A support and electrical connection structure for electric power meters, **characterized in that** it comprises:
- an elongated box-shaped housing (10),
- a plurality of power metal bars (20) which are arranged in the housing (10) substantially perpendicular to the housing longitudinal direction and substantially parallel to each other,
- a plurality of interconnection metal bars (21) which are arranged in the housing (10) substantially perpendicular to the housing longitudinal direction and substantially parallel to each other, each interconnection metal bar being connected to a corresponding power metal bar (20),
- a terminal board (12) attached to the housing (10) comprising a plurality of clamps for electrical connection to a plurality of user electrical networks,
- a plurality of positions (11) on a wall of the housing for mounting and electrically connecting power meters (23), each position (11) having associated thereto a power meter input electrical connection group (16) comprising members for connection to the interconnection metal bars (21), and a power meter output connection group (17) comprising members for connection to the clamps of the terminal board (12).

2. A combination of structures according to claim 1, wherein the box-shaped housings (10) are arranged side-by-side and have the respective power metal bars (20) connected to each other.
